# EUROPÄISCHE PATENTANMELDUNG

(11) **EP 3 613 809 A1**
(43) Veröffentlichungstag der Anmeldung: **26.02.2020**
(21) Anmeldenummer: 18190468.1
(22) Anmeldetag: 23.08.2018
(51) Int. Cl.: C08L 83/06, C09D 183/06, H01L 33/50

(54) **POLYMERES MATRIXMATERIAL, KONVERSIONSELEMENT, OPTOELEKTRONISCHES BAUELEMENT UND VERFAHREN ZUR HERSTELLUNG EINES OPTOELEKTRONISCHEN BAUELEMENTS**

(71) Anmelder: Universität des Saarlandes, 66123 Saarbrücken (DE)
(72) Erfinder: Kickelbick, Guido, 66386 St. Ingbert (DE); Steinbrück, Nils, 66117 Saarbrücken (DE); Meier, Dennis, 66606 St. Wendel (DE)
(74) Vertreter: Epping - Hermann - Fischer

(57) **Zusammenfassung**

Die Erfindung betrifft ein Konversionselement (100) für ein optoelektronisches Bauelement (1000) umfassend zumindest ein Konversionsmaterial (1), das zur Wellenlängenkonversion eingerichtet ist, ein polymeres Matrixmaterial (2), das durch Kondensationsreaktion von Trialkoxysilan- und Dialkoxysilanmonomereinheiten (3, 4) erzeugt ist, wobei das Konversionsmaterial (1) in dem Matrixmaterial (2) eingebettet ist.

## Beschreibung

Die Erfindung betrifft ein polymeres Matrixmaterial. Ferner betrifft die Erfindung ein Konversionselement. Ferner betrifft die Erfindung ein optoelektronisches Bauelement. Ferner betrifft die Erfindung ein Verfahren zur Herstellung eines optoelektronischen Bauelements.

Optoelektronische Bauelemente, beispielsweise Leuchtdioden, weisen in der Regel Konversionselemente auf, um die von einer Halbleiterschichtenfolge emittierte Strahlung in Strahlung mit veränderter, meist längerer Wellenlänge umzuwandeln. Das Konversionselement kann ein Matrixmaterial aufweisen, in dem ein anorganisches oder organisches Konversionsmaterial zur Wellenlängenkonversion eingebettet ist. Bisher sind kommerziell erhältliche Matrixmaterialien, wie beispielsweise Polydimethylsiloxane oder Polymethylphenylsiloxane, bekannt, die allerdings nur mäßige oder schlechte Eigenschaften im Hinblick auf Mischbarkeit, Verarbeitbarkeit, thermische und photophysikalische Stabilität in Bezug auf das organische Konversionsmaterial aufweisen.

Eine Aufgabe der Erfindung ist es, ein polymeres Matrixmaterial für ein optoelektronisches Bauelement bereitzustellen. Eine weitere Aufgabe der Erfindung ist es, ein Konversionselement bereitzustellen, das kostengünstig und leicht erzeugbar ist. Ferner ist es Aufgabe der Erfindung, ein optoelektronisches Bauelement und ein Verfahren zur Herstellung eines optoelektronischen Bauelements mit einem kostengünstigen und prozessoptimierten Konversionselement bereitzustellen bzw. zu erzeugen.

Diese Aufgaben werden durch ein Konversionselement gemäß dem unabhängigen Anspruch 1 gelöst. Vorteilhafte Ausgestaltungen und Weiterbildungen der Erfindung sind Gegenstand der abhängigen Ansprüche. Ferner werden diese Aufgaben durch ein polymeres Matrixmaterial, ein optoelektronisches Bauelement sowie durch ein Verfahren zur Herstellung eines optoelektronischen Bauelements gemäß den nebengeordneten Ansprüchen gelöst. Vorteilhafte Ausgestaltungen und Weiterbildungen des optoelektronischen Bauelements sind Gegenstand der entsprechenden abhängigen Ansprüche.

In zumindest einer Ausführungsform ist das polymere Matrixmaterial durch eine Kondensationsreaktion von Trialkoxysilan- und Dialkoxysilanmonomereinheiten erhältlich. Das polymere Matrixmaterial wird für ein optoelektronisches Bauelement verwendet oder in ein optoelektronisches Bauelement integriert. Beispielsweise kann das polymere Matrixmaterial als Matrixmaterial für ein Konversionselement, als Verguss, als Gehäuse oder als Verkapselung in einem optoelektronischen Bauelement verwendet werden.

In zumindest einer Ausführungsform weist das Konversionselement für ein optoelektronisches Bauelement ein Konversionsmaterial auf. Das Konversionselement ist zur Wellenlängenkonversion eingerichtet. Insbesondere wandelt das Konversionsmaterial eine elektromagnetische Strahlung in Strahlung mit veränderter, meist längerer Wellenlänge um. Das Konversionselement umfasst ein polymeres Matrixmaterial. Das polymere Matrixmaterial (kurz Matrixmaterial) ist durch eine Kondensationsreaktion von Trialkoxysilanmonomereinheiten und Dialkoxysilanmonomereinheiten (oder kurz Trialkoxysilan (TAS) oder Dialkoxysilan (DAS)) erzeugt oder erzeugbar. Das Konversionsmaterial ist in dem Matrixmaterial eingebettet. Die Einbettung kann homogen oder mit einem Konzentrationsgradienten erfolgen.

Die Erfindung betrifft ferner ein optoelektronisches Bauelement. Das optoelektronische Bauelement weist vorzugsweise das hier beschriebene Konversionselement auf. Dabei gelten alle gemachten Ausführungen und Definitionen für das Konversionselement auch für das optoelektronische Bauelement und umgekehrt.

Gemäß zumindest einer Ausführungsform weist das optoelektronische Bauelement eine Halbleiterschichtenfolge auf. Die Halbleiterschichtenfolge ist zur Emission von Primärstrahlung eingerichtet. Das optoelektronische Bauelement weist ein Konversionselement auf. Das Konversionselement ist im Strahlengang der Primärstrahlung angeordnet. Das Konversionselement ist zur Umwandlung der Primärstrahlung in Sekundärstrahlung eingerichtet. Alternativ oder zusätzlich kann das Konversionselement an den Seitenflächen der Halbleiterschichtenfolge angeordnet sein.

Die Erfindung betrifft ferner ein Verfahren zur Herstellung eines optoelektronischen Bauelements. Insbesondere wird mit dem hier beschriebenen Verfahren das hier beschriebene optoelektronische Bauelement erzeugt. Dabei gelten alle Definitionen und Ausführungen für das optoelektronische Bauelement oder das Konversionselement auch für das Verfahren zur Herstellung eines optoelektronischen Bauelements und umgekehrt.

Gemäß zumindest einer Ausführungsform weist das Verfahren zur Herstellung eines optoelektronischen Bauelements die folgenden Schritte auf:
A) Bereitstellen einer Halbleiterschichtenfolge, die zur Emission von Primärstrahlung eingerichtet ist,
B) Bereitstellen eines Konversionselements, das zur Umwandlung der Primärstrahlung in Sekundärstrahlung eingerichtet ist, dazu:
   B1) Erzeugen eines Matrixmaterials, dazu:
      B11) Säurekatalysierte Hydrolyse von Trialkoxysilan, wobei durch Kondensation teilvernetzte Strukturen erzeugt werden,
      B12) Einbau von Dialkoxysilan in die teilvernetzten Strukturen zur Ausbildung eines Gels,
      B13) Kondensation des Gels bei einer Temperatur zwischen 100 und 110 °C zur Erzeugung des Matrixmaterials, und B2) Einbetten eines Konversionsmaterials in das Matrixmaterial.

Insbesondere erfolgen die Schritte A) und B) in der hier angegebenen Reihenfolge. Der Verfahrensschritt B) kann in die Teilschritte B1) und B2) unterteilt werden. Der Teilschritt B1) kann wiederum in Subteilschritten B11), B12) und B13) erfolgen. Insbesondere erfolgt der Teilschritt B1) vor B2). Insbesondere erfolgen die Schritte B11), B12) und B13) in der hier angegebenen Reihenfolge als Subteilschritte des Teilschritts B1).

Gemäß zumindest einer Ausführungsform weist das optoelektronische Bauelement eine Halbleiterschichtenfolge auf. Bei der Halbleiterschichtenfolge kann es sich um einen Halbleiterchip handeln. Die Halbleiterschichtenfolge kann bevorzugt auf einem III-V-Verbindungshalbleitermaterial, beispielsweise einem Nitridverbindungshalbleitermaterial, wie Indiumgalliumnitrid, basieren.

Die Halbleiterschichtenfolge kann eine aktive Schicht mit mindestens einem pn-Übergang und/oder mit einer oder mit mehreren Quantentopfstrukturen aufweisen. Im Betrieb der Halbleiterschichtenfolge wird eine Primärstrahlung erzeugt. Die Primärstrahlung weist insbesondere eine Wellenlänge oder ein Wellenlängenmaximum der Strahlung im ultravioletten und/oder sichtbaren Spektralbereich, insbesondere Wellenlängen zwischen einschließlich 420 nm und einschließlich 680 nm, zum Beispiel zwischen einschließlich 440 nm und 480 nm, auf.

Insbesondere handelt es sich bei der Halbleiterschichtenfolge um eine indiumgalliumnitridbasierte Halbleiterschichtenfolge mit einem Wellenlängenmaximum von beispielsweise 450 nm. Alternativ kann der verwendete Spektralbereich der Primärstrahlung auch zwischen 500 nm und 700 nm liegen.

Bei dem optoelektronischen Bauelement kann es sich insbesondere um eine Leuchtdiode, kurz LED, handeln. Das optoelektronische Bauelement oder die Halbleiterschichtenfolge ist bevorzugt dazu eingerichtet, blaues Licht zu emittieren.

Gemäß zumindest einer Ausführungsform weist das optoelektronische Bauelement ein Konversionselement auf. Das Konversionselement ist insbesondere im Strahlengang der Primärstrahlung und/oder außerhalb des Strahlengangs der Primärstrahlung angeordnet. Das Konversionselement wandelt die Primärstrahlung in Sekundärstrahlung um. Die Sekundärstrahlung weist insbesondere in Bezug auf die Primärstrahlung eine längere oder größere Wellenlänge oder ein längeres oder größeres Wellenlängenmaximum auf.

Im Prinzip kann die Wellenlänge oder das Wellenlängenmaximum der Sekundärstrahlung bevorzugt im ultravioletten und/oder sichtbaren Spektralbereich liegen. Beispielsweise liegt die Primärstrahlung im blauen Spektralbereich, wohingegen die Sekundärstrahlung im gelben, roten oder grünen Spektralbereich liegt. Die Konversion kann vollständig oder nur teilweise erfolgen. Bei teilweiser Konversion kann weißes Mischlicht aus dem optoelektronischen Bauelement emittiert werden.

Gemäß zumindest einer Ausführungsform weist das Konversionselement ein Konversionsmaterial auf. Das Konversionsmaterial ist zur Wellenlängenkonversion eingerichtet. Das Konversionsmaterial ist insbesondere ein organischer Fluoreszenzfarbstoff. Der organische Fluoreszenzfarbstoff basiert insbesondere auf Perylendiimid oder Perylen. "Basieren" bedeutet hier insbesondere, dass der organische Fluoreszenzfarbstoff ein Perylendiimid oder Perylen oder ein Derivat davon ist. Das Grundgerüst des organischen Fluoreszenzfarbstoffs ist also ein Perylendiimid oder ein Perylen, wobei weitere Substituenten an dem Grundgerüst angebunden sein können.

Gemäß zumindest einer Ausführungsform ist das Konversionsmaterial ein anorganischer Leuchtstoff oder Mischungen aus weiteren anorganischen, weiteren organischen oder anorganischen und organischen Leuchtstoffen.

Der mindestens eine anorganische Leuchtstoff ist beispielsweise aus der folgenden Gruppe ausgewählt: Eu²⁺-dotierte Nitride, Granate, Eu²⁺-dotierte Sulfide, SiAlONe, Nitrido-Orthosilikate.

Alternativ ist das Konversionselement oder das optoelektronische Bauelement frei von einem anorganischen Leuchtstoff oder anorganischem Konversionsmaterial. Dies hat den Vorteil, dass derartige Konversionselemente preisgünstig herzustellen sind, da anorganische Leuchtstoffe in der Regel seltenerddotiert und damit teuer in ihrer Herstellung in Abhängigkeit von den rohstofffördernden Ländern sind.

Die Erfinder haben erkannt, dass durch das hier beschriebene Konversionselement, insbesondere mit dem hier beschriebenen Matrixmaterial, eine hervorragende Mischbarkeit zwischen dem Konversionsmaterial und dem Matrixmaterial erzielt werden kann. Zudem ist das Konversionselement gut verarbeitbar und zeigt eine signifikante Verbesserung der thermischen und photophysikalischen Stabilitäten des verwendeten Konversionsmaterials verglichen mit herkömmlichen Konversionselementen. Zudem kann das hier beschriebene Matrixmaterial im Vergleich zu kommerziell erhältlichen Polysiloxansystemen ohne Platinkatalysator und ohne eine zweite Komponente thermisch ausgehärtet werden. Daher ist das Konversionselement kosten- und prozessoptimiert herstellbar.

Gemäß zumindest einer Ausführungsform ist das Konversionsmaterial an dem Matrixmaterial kovalent angebunden. Als Konversionsmaterial kann beispielsweise der Farbstoff von BASF FC546 oder FC546-TES mit folgender Struktur verwendet werden:

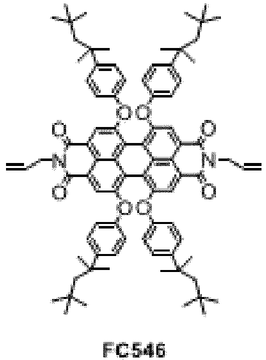

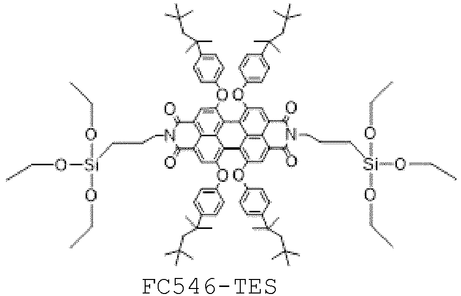

Gemäß zumindest einer Ausführungsform ist das Konversionsmaterial in dem Matrixmaterial nicht-kovalent angebunden. Beispielsweise kann als Konversionsmaterial hierfür das kommerziell erhältliche Lumogen® F 305 Rot mit folgender Struktur verwendet werden:

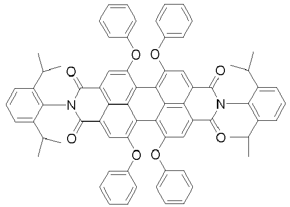

Gemäß zumindest einer Ausführungsform ist das Matrixmaterial bei Raumtemperatur fest oder gelartig. Zusätzlich oder alternativ ist das Konversionsmaterial ein organischer Fluoreszenzfarbstoff oder das Konversionsmaterial ist ein anorganischer Leuchtstoff.

Gemäß zumindest einer Ausführungsform weist die Trialkoxysilanmonomereinheit die Struktur (I) 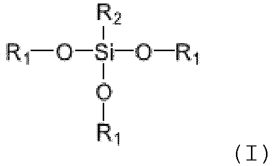 und/oder die Dialkoxysilanmonomereinheit die Struktur (II) 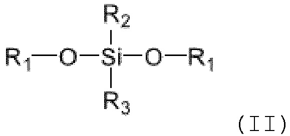 auf,
wobei R₁ für die jeweilige Trialkoxysilan- oder Dialkoxysilanmonomereinheit unabhängig voneinander aus Methyl oder Ethyl ausgewählt ist,
wobei R₂, R₃ für die jeweilige Trialkoxysilan- oder Dialkoxysilanmonomereinheit unabhängig voneinander aus Methyl oder Phenyl ausgewählt sind.

Alternativ können R₁, R₂ oder R₃ unabhängig voneinander aus anderen Alkylresten als den oben genannten Resten, substituierten Alkyresten oder Arylresten, wie Phenyl, ausgewählt werden.

Die Trialkoxysilan- und die Dialkoxysilanmonomereinheiten können beliebig miteinander polymerisiert werden und bilden das polymere Matrixmaterial.

Gemäß zumindest einer Ausführungsform sind die Trialkoxysilanmonomereinheiten verglichen mit den Dialkoxysilanmonomereinheiten im Überschuss in dem Matrixmaterial vorhanden.

Gemäß zumindest einer Ausführungsform wird das Matrixmaterial bei einer Temperatur zwischen 150 °C und 200 °C, insbesondere zwischen 150 °C und 180 °C, ausgehärtet und vollständig vernetzt. Alternativ kann die Aushärtung bei Temperaturen von kleiner als 150 °C je nach Zusammensetzung des Matrixmaterials erfolgen.

Gemäß zumindest einer Ausführungsform liegt das Verhältnis von Trialkoxysilanmonomereinheiten (TAS) zu Dialkoxysilanmonomereinheiten (DAS) zwischen 85:15 und 100:0, bevorzugt zwischen 85:15 und 99:1, besonders bevorzugt zwischen 86:14 und 90:10, beispielsweise bei 87:13, bezogen auf das Matrixmaterial.

Gemäß zumindest einer Ausführungsform ist das Matrixmaterial fest, gel- oder glasartig. Das Matrixmaterial kann bei Raumtemperatur fest oder gelartig sein. Das Matrixmaterial fließt bei einer Temperatur > T1 und konsolidiert bei Temperaturen > T2 (T2 > T1). Das Matrixmaterial kann auch hier als sogenanntes Melting Gel (MG) bezeichnet werden. Das Matrixmaterial kann ein organisch modifiziertes Siloxangel sein.

Das Matrixmaterial kann über einen säurekatalysierten Sol-Gel-Prozess erzeugt werden. Nach erfolgreicher Herstellung kann das Matrixmaterial reversibel aufgeschmolzen und verarbeitet werden. Das Matrixmaterial kann in vielen organischen Lösungsmitteln löslich sein. Beim Aufschmelzen des Matrixmaterials kann es zur Vernetzung kommen. Hält man die Temperaturen möglichst klein, läuft der Vernetzungsprozess äußerst langsam ab, was eine erhöhte Verarbeitungszeit zur Folge hat. Erhöht man die Temperatur, kann die Vernetzungsdauer, auch Konsolidierungszeit genannt, zwischen 1,5 und 94 Stunden liegen. Ist das Matrixmaterial vollständig konsolidiert, kann es nicht mehr aufgeschmolzen oder in organischen Lösungsmitteln gelöst werden.

Das Matrixmaterial eignet sich hervorragend für die hier beschriebenen erfindungsgemäßen Konversionselemente oder optoelektronischen Bauelemente.

Der Schmelzvorgang des Matrixmaterials bei T1 kann mehrfach wiederholbar sein. Die Konsolidierung bei T2 hingegen kann zu einer irreversiblen und permanenten Erhärtung des Matrixmaterials führen. Die Eigenschaften des nicht konsolidierten Matrixmaterials können über das Verhältnis der eingesetzten Monomere, insbesondere von Trialkoxysilan- und Dialkoxysilanmonomeren, gesteuert werden.

Das Matrixmaterial ist gemäß zumindest einer Ausführungsform in organischen Lösungsmitteln, wie beispielsweise Toluol, Chloroform, Aceton oder Diethylether, vollständig löslich. Das konsolidierte Matrixmaterial kann transparent und thermisch belastbar (> 200° C), hydrophob und/oder sehr hart sein.

Gemäß zumindest einer Ausführungsform weist das Matrixmaterial die folgende Struktur auf: 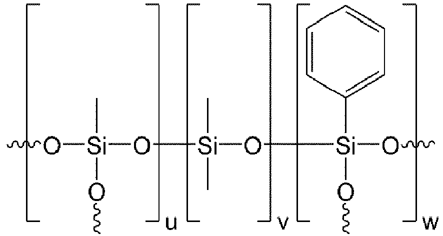 wobei insbesondere u + v + w die Anzahl der eingesetzten Si-Atome ist. Alternativ oder zusätzlich kann u, v und w jeweils einen Wert zwischen 1 und 20 000, insbesondere 1 bis 15 000, besonders bevorzugt 1 bis 10 000 aufweisen.

Gemäß zumindest einer Ausführungsform weist das Matrixmaterial die folgende Struktur auf: 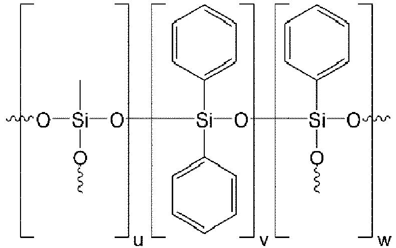 wobei insbesondere u + v + w die Anzahl der eingesetzten Si-Atome ist. Alternativ oder zusätzlich kann u, v und w jeweils einen Wert zwischen 1 und 20 000, insbesondere 1 bis 15 000, besonders bevorzugt 1 bis 10 000 aufweisen.

Gemäß zumindest einer Ausführungsform weist das Matrixmaterial die folgende Struktur auf: 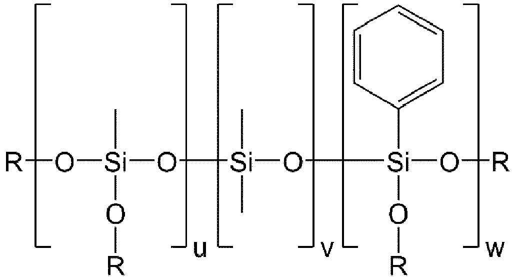 wobei insbesondere u + v + w die Anzahl der eingesetzten Si-Atome ist. Alternativ oder zusätzlich kann u, v und w jeweils einen Wert zwischen 1 und 20 000, insbesondere 1 bis 15 000, besonders bevorzugt 1 bis 10 000 aufweisen.

Gemäß zumindest einer Ausführungsform weist das Matrixmaterial die folgende Struktur auf: 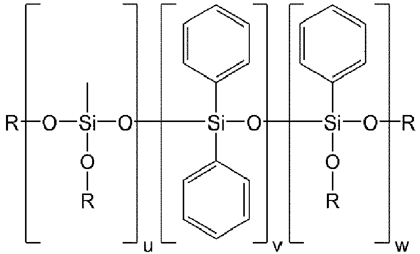 wobei insbesondere u + v + w die Anzahl der eingesetzten Si-Atome ist. Alternativ oder zusätzlich kann u, v und w jeweils einen Wert zwischen 1 und 20 000, insbesondere 1 bis 15 000, besonders bevorzugt 1 bis 10 000 aufweisen.

Gemäß zumindest einer Ausführungsform umhüllt das Konversionselement die Halbleiterschichtenfolge vollständig. Insbesondere umhüllt das Konversionselement die Halbleiterschichtenfolge stoff- und formschlüssig.

Alternativ ist das Konversionselement von den Halbleiterschichten beabstandet angeordnet (Remote Phosphor). Alternativ sind auch andere Ausgestaltungen des Konversionselements möglich, so dass beispielsweise das Konversionselement die Seitenflächen der Halbleiterschichtenfolge bedeckt und/oder die Strahlungsaustrittsfläche der Halbleiterschichtenfolge frei von dem Konversionselement ist. Strahlungsaustrittsfläche kann hier die quer zur Wachstumsrichtung der Halbleiterschichtenfolge angeordnete Fläche der Halbleiterschichtenfolge meinen. Seitenflächen der Halbleiterschichtenfolge sind hier insbesondere die quer zur Strahlungsaustrittsfläche der Halbleiterschichtenfolge angeordneten Flächen der Halbleiterschichtenfolge.

Gemäß zumindest einer Ausführungsform wird das Matrixmaterial ohne Edelmetallkatalysator, beispielsweise ohne Platinkatalysator, erzeugt. Zusätzlich kann das Matrixmaterial ohne Zusatz weiterer Komponenten ausgehärtet werden.

Weitere Vorteile, vorteilhafte Ausführungsformen und Weiterbildungen ergeben sich aus den im Folgenden in Verbindung mit den Figuren beschriebenen Ausführungsbeispielen. Es zeigen:
Figuren 1A bis 1C jeweils ein Verfahren zur Herstellung eines Matrixmaterials,
Figuren 2A bis 2C Konversionsmaterialien gemäß einer Ausführungsform,
Figur 3 Konversionsmaterialien und Matrixmaterialien für ein Konversionselement gemäß einer Ausführungsform,
Figuren 4A bis 4E jeweils ein optoelektronisches Bauelement gemäß einer Ausführungsform,
Figuren 5A bis 5D Emissionsspektren gemäß jeweils einer Ausführungsform,
Figuren 6A und 6B relative Extinktionen gemäß jeweils einer Ausführungsform,
Figuren 7A bis 7D FTIR-Spektren gemäß jeweils einer Ausführungsform,
Figuren 8A bis 8D NMR-Spektren gemäß jeweils einer Ausführungsform,
Figur 9 theoretische und berechnete Phenylgehalte der NMR-Spektren gemäß einer Ausführungsform,
Figuren 10A und 10B ¹H-NMR-Spektren eines Konversionsmaterials in Chloroform-D,
Figur 11 Thermogravimetriekurven gemäß einer Ausführungsform,
Figur 12 UV/VIS-Spektroskopiemessungen gemäß einer Ausführungsform, und
Figur 13 Transmissionswerte des Matrixmaterials gemäß einer Ausführungsform.

In den Ausführungsbeispielen und Figuren können gleiche, gleichartige oder gleichwirkende Elemente jeweils mit denselben Bezugszeichen versehen sein. Die dargestellten Elemente und deren Größenverhältnisse untereinander sind nicht als maßstabsgerecht anzusehen. Vielmehr können einzelne Elemente, wie zum Beispiel Schichten, Bauteile, Bauelemente und Bereiche zur besseren Darstellbarkeit und/oder zum besseren Verständnis übertrieben groß dargestellt werden.

Gemäß zumindest einer Ausführungsform erfolgt die Herstellung des Matrixmaterials in einem vielstufigen Prozess durch eine Kondensationsreaktion von Trialkoxysilan- und Dialkoxysilanmonomereinheiten. Diese Monomere bilden ein teilkondensiertes Netzwerk mit den oben beschriebenen Eigenschaften. Bei T2 kann es zur vollständigen Kondensation des Netzwerkes kommen.

Gemäß zumindest einer Ausführungsform kann das Matrixmaterial über einen mehrstufigen Prozess erzeugt werden, wobei zuerst eine säurekatalysierte Hydrolyse eines Trialkoxysilans in Salzsäure durchgeführt wird. Dieses reagiert durch Kondensation zu Polysiloxanketten und teilvernetzten Strukturen. Durch den anschließenden Einbau eines Dialkoxysilans können die späteren Materialeigenschaften eingestellt werden. Das teilkondensierte Gemisch kann unter Bildung eines Gels gerührt werden. Optional können Aufreinigungsschritte, wie beispielsweise Waschen oder Filtration, erfolgen. Zuletzt kann das Matrixmaterial bei 70 und 100 bis 110 °C weiter kondensiert werden.

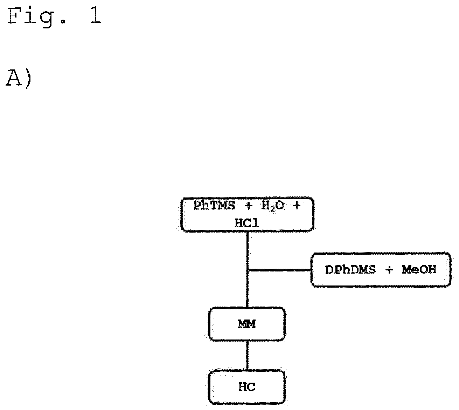

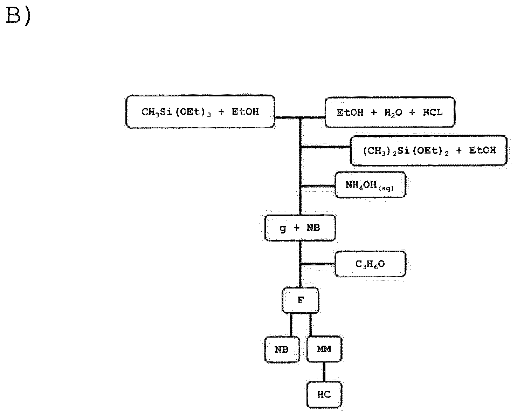

Gemäß zumindest einer Ausführungsform kann das Matrixmaterial nach den folgenden zwei Synthesemöglichkeiten (Figuren 1A und 1B) erzeugt werden. Insbesondere erfolgt die Herstellung des hier beschriebenen Matrixmaterials nach Synthesemöglichkeit 1. Die Synthesemöglichkeit 2 beinhaltet insbesondere eine zusätzliche Synthese und einen Aufreinigungsschritt.

Die Figur 1A zeigt eine schematische Synthesemöglichkeit 1 zur Herstellung eines Matrixmaterials. Das Matrixmaterial kann über einen mehrstufigen Prozess erzeugt werden. Ein oder mehrere Trialkoxysilanmonomere (TAS), beispielsweise PhTMS - Phenyltrimethoxysilan, werden in Salzsäure ((pH = 2.5; n(TAS)/n(H2O)) = 1/1.5) verschlossen gerührt (40 °C, 6 h). Ein oder mehrere Dialkoxysilanmonomere (DAS), beispielsweise DPhDMA - Diphenyldimethoxysilan, werden im molaren Verhältnis 1:4 mit einem Alkohol (je nach Alkoxysilangruppe: Methanol, Ethanol etc.) verrührt, dem ersten Gemisch zugetropft, welches weiter gerührt wird (40 °C, 2 h). Das verschlossene Gefäß kann geöffnet und das Gemisch weiter gerührt werden bis es geliert (25 °C, 12 - 24 h). Das Gemisch wird anschließend im Ofen erwärmt, um Lösungsmittelreste zu entfernen (70 °C, 12 - 24 h). Das Gemisch wird erneut erwärmt, um Wasserreste zu entfernen (100 - 110 °C, 0.5 - 24 h). Es resultiert das Matrixmaterial (MM), das für das Konversionselement verwendet werden kann. Alternativ kann das Matrixmaterial für Beschichtungsprozesse verwendet werden. Das Matrixmaterial kann bei der Konsolidierungstemperatur für 24 h thermisch behandelt werden und eine dicke Hybridbeschichtung HC bilden.

Die Figur 1B zeigt eine alternative Synthesemöglichkeit zur Erzeugung eines Matrixmaterials. Das Matrixmaterial kann über einen mehrstufigen Prozess erzeugt werden. Ein oder mehrere Trialkoxysilanmonomere (TAS) werden mit einem Alkohol (je nach Alkoxysilangruppe: Methanol, Ethanol, etc.) mit Wasser und Salzsäure im molaren Verhältnis 1:4:3:0.01 verschlossen gerührt (40 °C, 6 h). Ein oder mehrere Dialkoxysilanmonomere (DAS) werden im molaren Verhältnis 1:4 mit einem Alkohol (je nach Alkoxysilangruppe: Methanol, Ethanol etc.) verrührt und dem ersten Gemisch zugetropft, welches weiter gerührt wird (40 °C, 2 h). Es wird dem Gemisch eine Ammoniumhydroxidlösung zugegeben und weiter gerührt (40 °C, 1 h). Das verschlossene Gefäß wird geöffnet und das Gemisch weiter gerührt bis es geliert (G, NB - Nebenprodukt 25 °C, 0.5 - 96 h). Das gelierte Material wird offen im Ofen erwärmt, um Alkoholreste zu entfernen (70 °C, 12 - 24 h). Ausgefallenes Ammoniumchlorid wird durch Waschen mit Aceton (10 ml) und Filtration F unter vermindertem Druck entfernt. Zu dem Gemisch wird eine definierte Menge eines organischen Fluoreszenzfarbstoffs zugegeben und mechanisch eingearbeitet. Das Material wird erneut erwärmt, um Wasserreste zu entfernen (100 - 110 °C, 0.5 - 24 h). Es resultiert das Matrixmaterial (MM), das für das Konversionselement verwendet werden kann. Alternativ oder zusätzlich kann das Matrixmaterial für Beschichtungsprozesse verwendet werden. Das Matrixmaterial kann bei der Konsolidierungstemperatur für 24h thermisch behandelt werden und eine dicke Hybridbeschichtung HC bilden.

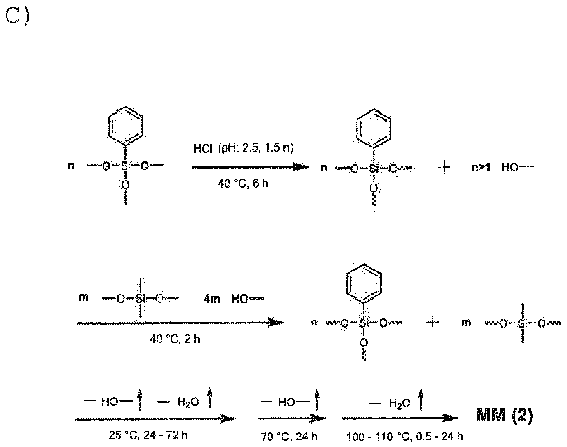

Die Figur 1C zeigt die Reaktionsgleichung zur Darstellung eines Matrixmaterials, beispielsweise eines Phenylmethylmatrixmaterials (MM, 2). Dabei erfolgt eine säurekatalysierte Hydrolyse eines Trialkoxysilans in Salzsäure. Dieses reagiert durch Kondensation zu Polysiloxanketten und teilvernetzten Strukturen. Durch den anschließenden Einbau eines Dialkoxysilans können die späteren Materialeigenschaften eingestellt werden. Das teilkondensierte Gemisch kann unter Bildung eines Gels gerührt werden. Optional können Aufreinigungsschritte, wie Waschen oder Filtration, erfolgen. Zudem kann das Matrixmaterial bei 70° C für 24 Stunden und bei 100 bis 110 °C für 0,5 bis 24 Stunden weiter kondensiert werden.

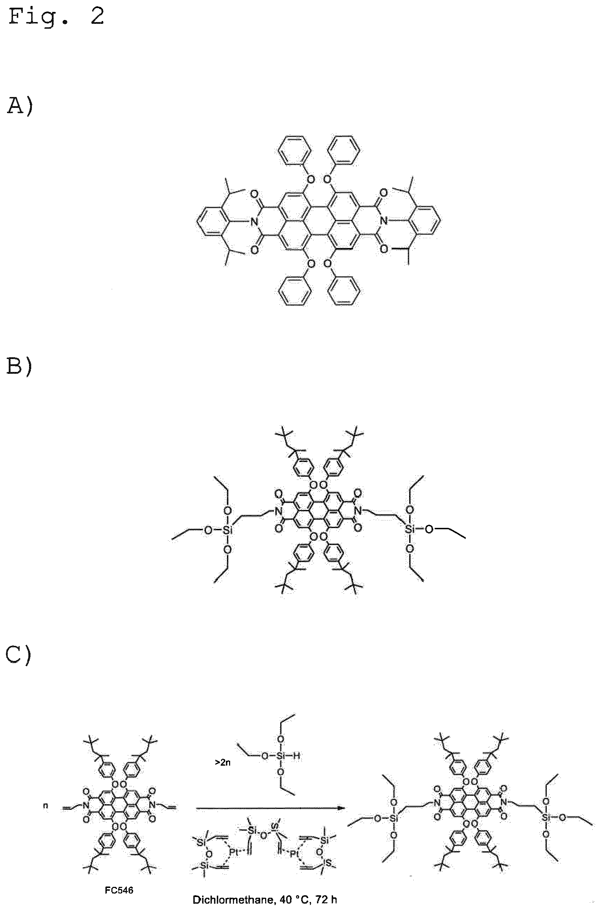

Die Figuren 2A bis 2C zeigen Konversionsmaterialien gemäß einer Ausführungsform. Insbesondere ist das Konversionsmaterial ein organischer Fluoreszenzfarbstoff. Der organische Fluoreszenzfarbstoff basiert vorzugsweise auf Perylen oder Perylendiimid.

Figur 2A zeigt das kommerziell erhältliche Perylendiimid Lumogen® F 305 Rot.

Figur 2B zeigt den von BASF erhältlichen organischen Fluoreszenzfarbstoff FC546. Dieser organische Fluoreszenzfarbstoff basiert auf Perylendiimid, welches durch Triethoxysilanendgruppen kovalent in das Matrixmaterial eingebunden werden kann. Die Darstellung des FC546-TES kann über eine Hydrolysierungsreaktion erfolgen (Figur 2C). Der Einbau des Konversionsmaterials in das Matrixmaterial kann den oben beschriebenen Synthesevorschriften entnommen werden.

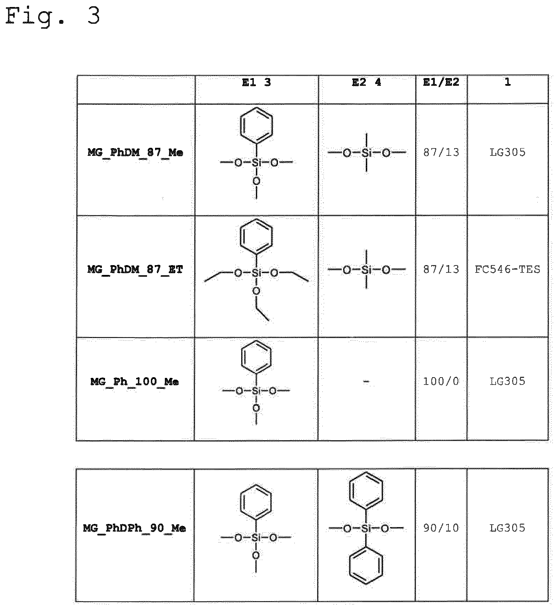

Die Figur 3 zeigt jeweilige Ausführungsbeispiele eines Konversionselements. Hier wurde das Matrixmaterial gemäß der Synthesemöglichkeit 1 nach Figur 1A erzeugt. Das Konversionsmaterial 1 wurde in das Matrixmaterial eindispergiert.

Die Tabelle der Figur 3 zeigt vier Ausführungsbeispiele für das Konversionselement 100. Die Ausführungsbeispiele werden in der Spalte 1 mit der jeweiligen Abkürzung benannt. Spalte 2 (E1, 3) zeigt die Trialkoxysilanmonomereinheiten. Spalte 3 (E2, 4) zeigt die Dialkoxysilanmonomereinheiten. Spalte 4 zeigt das Verhältnis der Trialkoxysilanmonomereinheiten zu den Dialkoxysilanmonomereinheiten und Spalte 5 zeigt das Konversionsmaterial 1, welches hier verwendet wird. LG305 bezeichnet Lumogen® F 305 Rot. FC546-TES bezeichnet das in Figur 2C dargestellte Konversionsmaterial 1. Insbesondere ist das Matrixmaterial 2 fest, aber formbar und kann bei Temperaturen von größer als 110 °C konsolidiert werden.

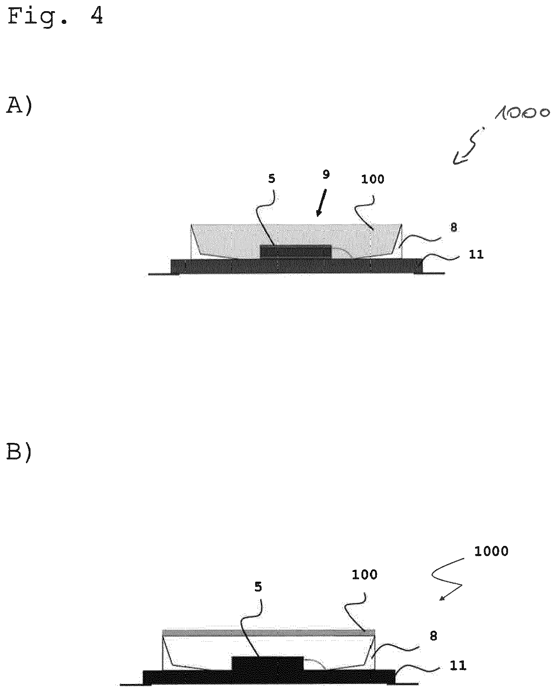

Die Figuren 4A und 4B zeigen jeweils ein optoelektronisches Bauelement 1000 gemäß einer Ausführungsform.

Das optoelektronische Bauelement 1000 weist jeweils ein Substrat 11 auf. Auf dem Substrat 11 ist eine Halbleiterschichtenfolge 5 angeordnet. Die Halbleiterschichtenfolge 5 ist zur Emission von Primärstrahlung eingerichtet. Die Halbleiterschichtenfolge 5 kann ein Halbleiterchip aus InGaN sein, der kurzwelliges Licht, beispielsweise mit einem Wellenlängenmaximum von 450 nm, erzeugt.

Im Strahlengang der Primärstrahlung ist ein Konversionselement 100 angeordnet. In der Figur 4A umhüllt das Konversionselement 100 die Halbleiterschichtenfolge 5 vollständig, das heißt stoff- und formschlüssig. Das Konversionselement 100 ist hier als Verguss in einer Ausnehmung 9 eines Gehäuses 8 eingebracht. Das Konversionselement 100 weist ein Konversionsmaterial 1 auf, das in dem Matrixmaterial 2 eingebettet ist (hier nicht gezeigt).

Die Figur 4B zeigt hingegen, dass das Konversionselement 100 von der Halbleiterschichtenfolge 5 beabstandet angeordnet ist. Diese Anordnung kann auch als Remote-Anwendung bezeichnet werden.

Insbesondere emittiert das optoelektronische Bauelement in beiden Ausführungsformen weißes Licht. Das Licht kann warmweiß oder kaltweiß sein. Insbesondere ist das Konversionsmaterial 1 organisch und frei von anorganischen Farbstoffen. Das hier verwendete Matrixmaterial 2 sollte für die hier beschriebenen Anwendungen eine hohe Löslichkeit für das gewählte Konversionsmaterial 1, eine hohe thermische und photophysikalische Beständigkeit, eine hohe Transparenz und Verarbeitbarkeit aufweisen, sowie durch eine thermische Behandlung irreversibel in einen festen, beständigen Zustand übergehen. Zusätzlich sollte das Matrixmaterial 2 einen garantierten Schutz des gelösten organischen Konversionsmaterials 1 vor extrinsischen und intrinsischen Einflüssen garantieren.

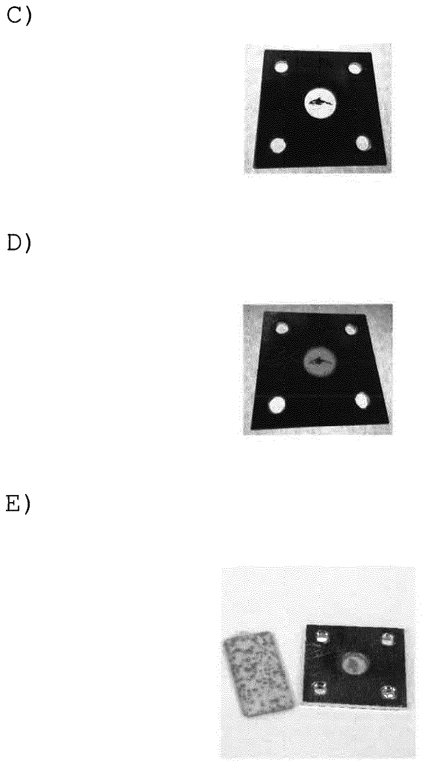

Die Figur 4C zeigt ein konsolidiertes Matrixmaterial MG(Kons.)-PhDM-87-Me. Die Figur 4D zeigt ein konsolidiertes Matrixmaterial MG(Kons.)-PhDM-87-Me-LG305-1000. Die Figur 4E zeigt ein konsolidiertes Matrixmaterial MG(Kons.)-DMP87-ME-LG305-1000 Granulat in Dow Corning OE6630.

Hier wurde ein Teil des hergestellten Matrixmaterials bei 110 °C aufgeschmolzen und für weitere Untersuchungen in einem Aluminiumrahmen vergossen und bei mindestens 160 °C für 72 Stunden konsolidiert. Die erhaltenen Probenkörper konnten nicht alle rissfrei erhalten werden.

Ein Teil des Matrixmaterials wurde ebenfalls bei mindestens 160 °C für 72 Stunden konsolidiert und anschließend zu einem Granulat gemörsert. Dieses wurde in ein kommerziell erhältliches Polysiloxan (Dow Corning OE6630) eingebracht, welches anschließend nach Herstellerangaben ausgehärtet wurde. Die Aushärtung erfolgte als Probenkörper in einer Teflonform und ebenfalls in einer Aluminiumform (siehe Figur 4E) .

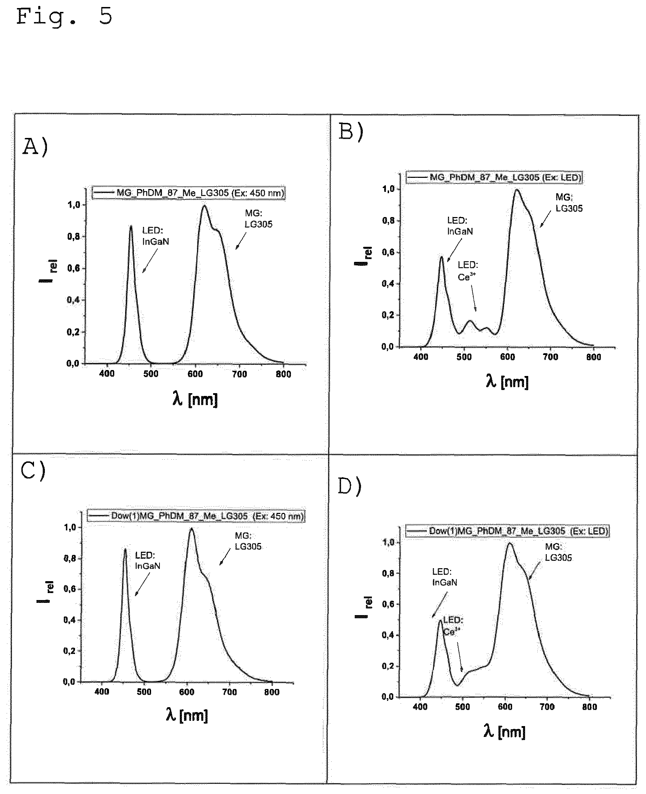

Die Figuren 5A bis 5D zeigen jeweils die relative Intensität Iᵣₑₗ in Abhängigkeit von der Wellenlänge λ in nm. Die Ausführungsformen der Figuren 5A und 5C wurden mit einer Indiumgalliumnitrid-Lichtquelle mit einer Wellenlänge von 450 nm angeregt. Die Lichtanregung der Ausführungsformen der Figuren 5B und 5D erfolgte mit einer handelsüblichen Weißlicht-LED.

Die Figuren 5A und 5B zeigen das Matrixmaterial mit dem Konversionsmaterial LG305 (MG-PhDM-87-Me-LG305). Die Figuren 5C und 5D zeigen das Matrixmaterial mit dem Konversionsmaterial LG305 (MG-PhDM-87-Me-LG305) als Granulat in Dow Corning OE6630.

Um die Applizierbarkeit des Matrixmaterials in LEDs simulativ zu überprüfen, wurde das mit Farbstoff versetzte Matrixmaterial in zwei verschiedenen experimentellen Aufbauten untersucht. Im ersten wurde das Matrixmaterial in einem Fluoreszenzspektrometer mit einer InGaN-450 nm-Lichtquelle bestrahlt. Dies simuliert einen LED-Aufbau für eine rote, rein organische LED ohne Seltenerdanteile (Figuren 5A und 5C).

Im zweiten Aufbau wurde das Matrixmaterial in einem Fluoreszenzspektrometer mit einer handelsüblichen Kaltlicht-LED bestrahlt (Figuren 5B und 5D). Hier wird neben der InGaN-450 nm-Lichtquelle auch ein anorganischer Emitter verwendet, der den Spektralbereich zwischen 500 und 700 nm abdeckt. Dies simuliert einen seltenerdreduzierten Aufbau, bei dem ein anorganischer Rotemitter durch einen organischen substituiert wird.

In beiden Fällen entspricht dies einem simulierten Remoteaufbau.

Die hier beschriebenen Emissionsspektren der Figuren 5A bis 5D zeigen typische Emissionsbilder von Rot- oder Warmweiß-LEDs. Das Matrixmaterial ist somit hervorragend für eine Anwendung in optoelektronischen Bauelementen geeignet und kann auch als Verkapselung, als Laminierung oder als Granulat mit und ohne eingebautem Konversionsmaterial, beispielweise organischem Farbstoff, eingesetzt werden.

Das Matrixmaterial kann insbesondere auch als fluoreszierendes LED-Verkapselungsmaterial, als Laminierung oder Mikropartikelhybridmaterial mit silikonbasierten Verkapselungsmaterialien eingesetzt werden.

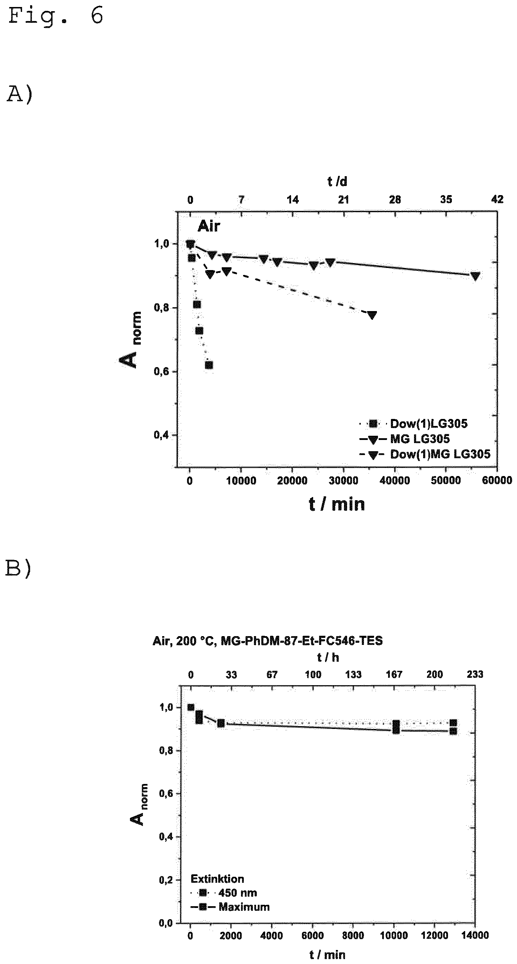

Die Figur 6A zeigt die relative Extinktion Aₙₒᵣₘ aufgetragen gegen die Zeit t der Belichtung in min bei 450 nm von Dow Corning OE6630 mit LG305 (Dow (1) LG305), von MG-PhDM-87-Me-LG305 (MG LG305) und von einem Granulat aus konsolidiertem MG-PhDM-87-Me-LG305 in Dow Corning OE6630 (Dow(1)MG LG305) an Luft.

Neben der Applizierbarkeit des Matrixmaterials in optoelektronischen Bauelementen ist auch eine erhöhte Stabilität des Konversionsmaterials, insbesondere von organischen Fluoreszenzfarbstoffen, im Betrieb notwendig.

Um die photophysikalische Stabilität zu untersuchen, wurde als Ausführungsbeispiel MG-PhDM-87-Me-LG305 als konsolidierter Verguss und als Granulat im Dow Corning OE6630 über einen längeren Zeitraum belichtet (450 nm, 850 mW/cm²). Anschließend wurde die Extinktion (Aₙₒᵣₘ) der Probenkörper mittels UV/VIS-Spektroskopie gemessen. Es wurde die Extinktion bei 450 nm gegen die Zeit aufgetragen, wobei im Verlauf eine Abnahme der Farbstoffkonzentration durch Belichtung erfolgt. Zum Vergleich werden die Ergebnisse der Belichtung des Konversionsmaterials LG305 ohne Matrixmaterial im Dow Corning OE6630 gezeigt.

Eine Abnahme von 10% im Matrixmaterial 2 tritt erst nach 928 Stunden (ungefähr 39 Tagen) auf, was eine Erhöhung der Stabilität um ca. 8400% im Vergleich zum Farbstoff im Dow Corning ist. Auch das Granulat des Matrixmaterials zeigt im Dow Corning eine erhöhte Stabilität. Als weiteren thermischen ersten Stabilitätstest wurde das MG-PhDM-87-Et-FC546-TES für 215 Stunden bei 200 °C im Backofen getempert. Anschließend wurde die Extinktion der Probenkörper mittels UV/VIS-Spektroskopie gemessen. Die Auftragung der Extinktion gegen die Zeit zeigt in etwa die Abnahme der Farbstoffkonzentration durch die thermische Behandlung.

Die Figur 6B zeigt die relative Extinktion Aₙₒᵣₘ aufgetragen gegen die Zeit t in min der Temperaturbehandlung bei 200 °C von MG-PhDM-87-Et-FC546-TES an Luft. Die Temperaturbehandlung führt innerhalb des gemessenen Zeitraums nur zu geringen Änderungen der Extinktion über die Zeit.

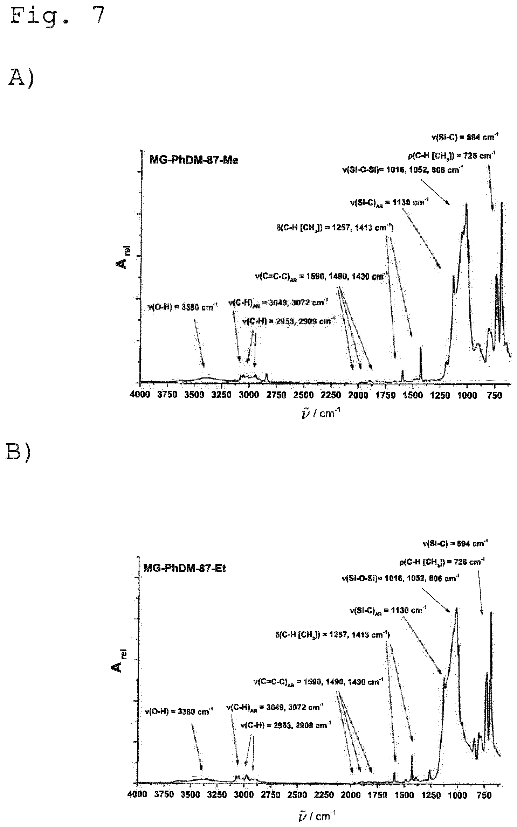

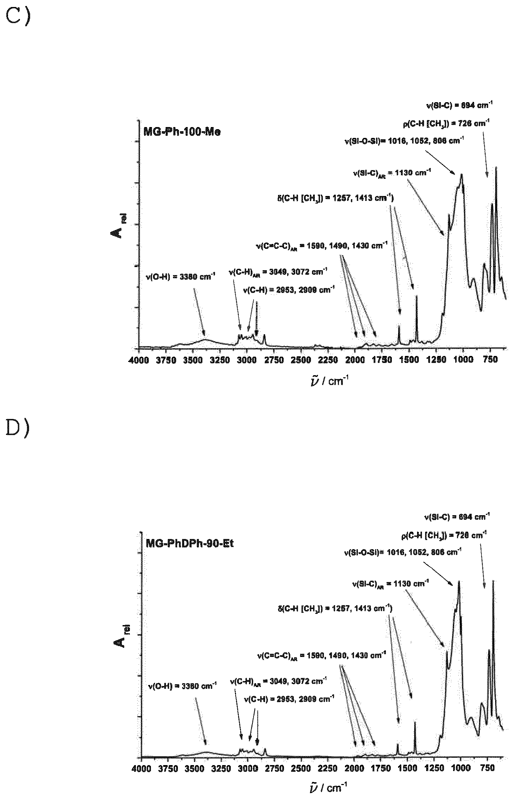

Die Figuren 7A bis 7D zeigen FTIR-Spektren von verschiedenen Ausführungsbeispielen (Figur 7A: MG_PhDM_87_Me, Figur 7B: MG_PhDM_87_Et, Figur 7C: MG_Ph_100_Me und Figur 7D: MG_PhDPh_90_Me). Es ist die relative Absorption Aᵣₑₗ in Abhängigkeit von der Wellenzahl v in cm⁻¹ gezeigt. Die FTIR-Spektroskopie erfolgt, um die Reinheit der erfolgreichen Polykondensation der einzelnen Matrixmaterialien zu quantifizieren. Alle Matrixmaterialien zeigen die typischen Schwingungsbanden im FTIR-Spektrum:
Schwingungsbanden (cm⁻¹): 3380 v(O-H) ; 3049, 3072 v(C-H)_{AR}; 2953, 2909 v(C-H); 1590, 1490, 1430 [v(C=C-C)_{AR}] ; 1413, 1257 [δ(C-H[Si-CH₃])]; 1130 δ(Si-C)_{AR}; 1052, 1016, 806 [v(Si-O-Si)]; 726 [ρ(C-H[Si-(CH₃)₂])]; 694 [v(Si-C)].

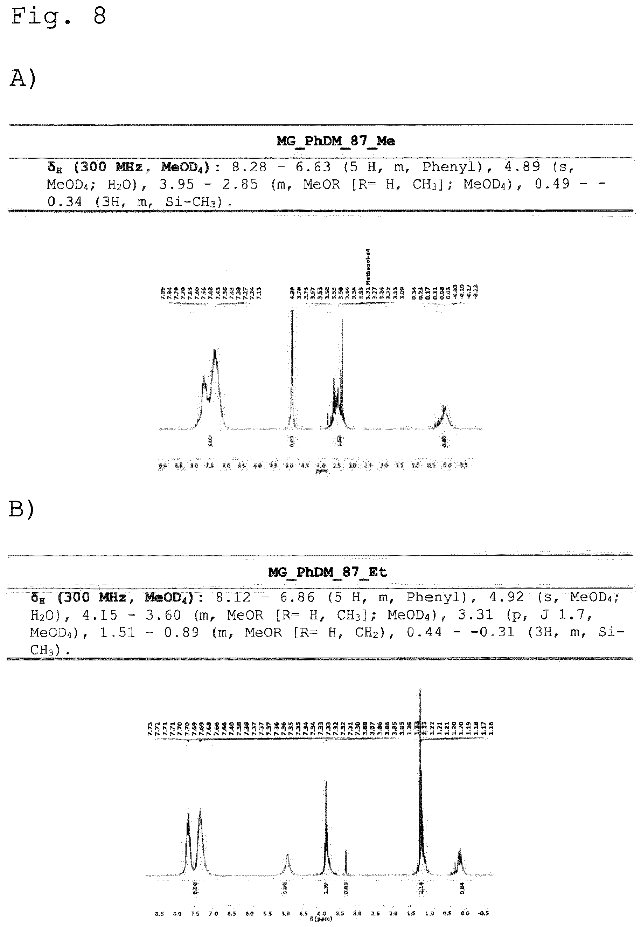

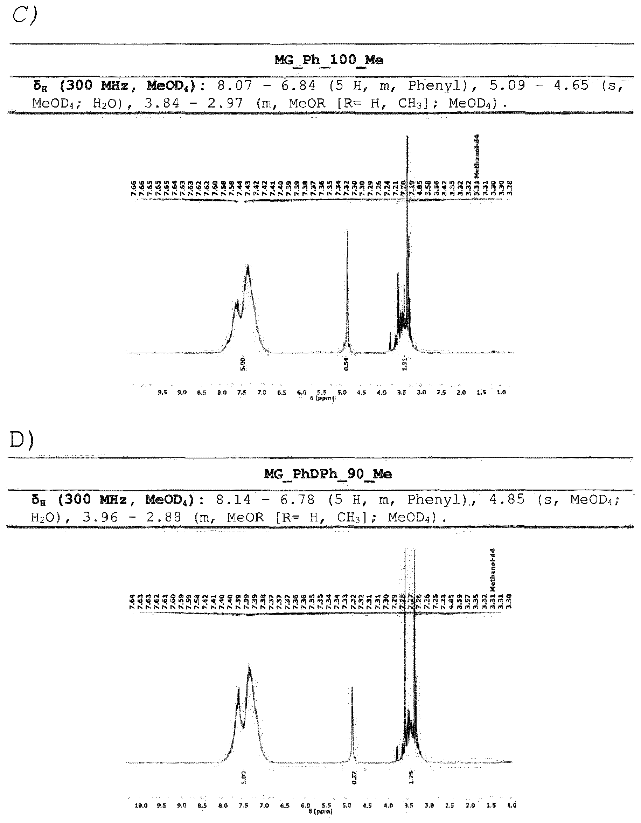

Die Figuren 8A bis 8D zeigen NMR-Spektren (¹H-NMR-Spektren) von verschiedenen Ausführungsbeispielen in Methanol-D4 (Figur 8A: MG_PhDM_87_Me, Figur 8B: MG_PhDM_87_Et, Figur 8C: MG_Ph_100_Me und Figur 8D: MG_PhDPh_90_Me).

Die ¹H-NMR-Spektren der dargestellten Matrixmaterialien zeigen die zu erwartende chemische Verschiebung für Phenylmethyl beziehungsweise Phenylpolysiloxane. Für die methylhaltigen Matrixmaterialien wurden aus den NMR-Daten die prozentualen Anteile an Phenylgruppen bestimmt. Diese weichen nur geringfügig von den berechneten Werten aus der Einwaage ab. Eine solche Bestimmung für die rein phenylhaltigen Systeme ist nicht möglich.

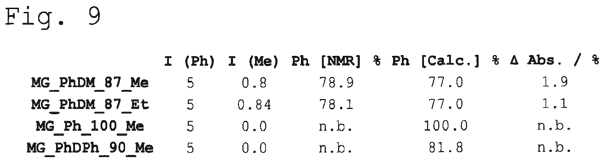

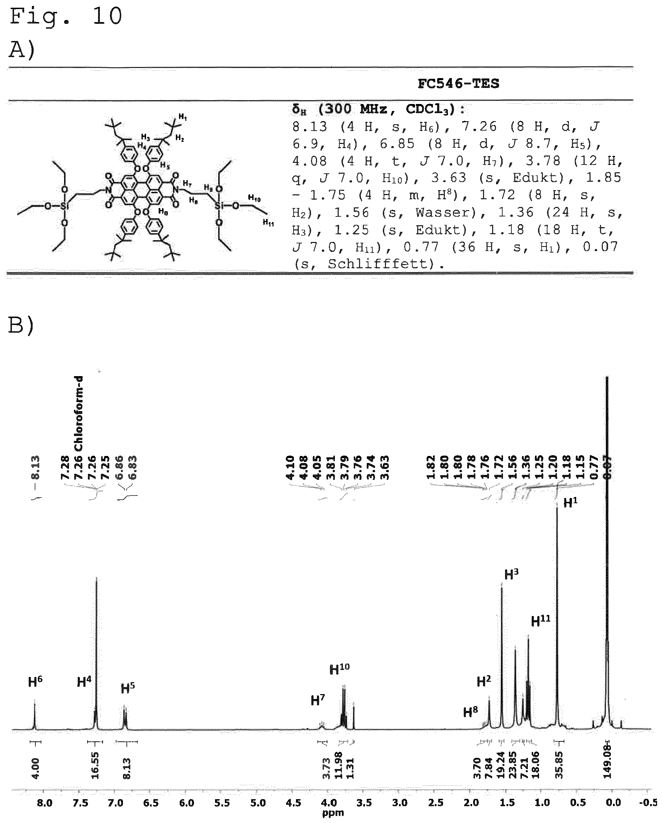

Die Figur 9 zeigt die theoretischen und berechneten Phenylgehalte aus der NMR-Spektroskopie der Ausführungsbeispiele der Figuren 8A bis 8D. Die starke Verbreitung der chemischen Verschiebung der einzelnen Gruppen ist auf die starke Ausbildung von Polymerstrukturen zurückzuführen. Der zur kovalenten Einbindung dargestellte Fluoreszenzfarbstoff FC546-TES wurde ebenfalls mittels NMR-Spektroskopie untersucht (siehe Figuren 10A und 10B). Das ¹H-NMR-Spektrum zeigt chemische Verschiebungen, die auf leichte Verunreinigungen des Edukts Triethoxysilan und Schlifffett zurückzuführen sind. Alle weiteren Verschiebungen sind dem Produkt zugeordnet.

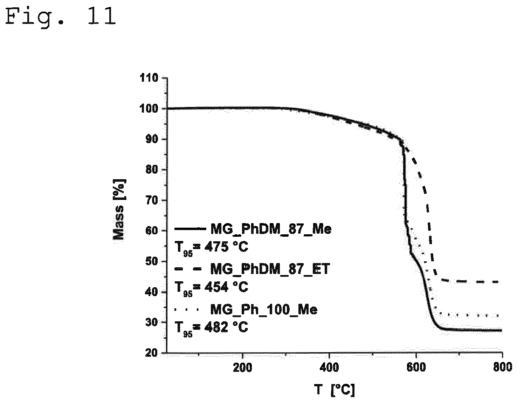

Die Figur 11 zeigt thermogravimetrische Kurven zur Bestimmung der thermischen Beständigkeit für drei der vier Matrixmaterialien gemäß einer Ausführungsform. Es ist die Masse (Mass) in % in Abhängigkeit von der Temperatur T in °C dargestellt. Die Materialproben wurden in einer O₂/N₂ Atmosphäre (50/50) mit 20K/min auf 800 °C erhitzt. Als definierter Wert für die thermische Beständigkeit wird der sogenannte T₉₅-Wert ermittelt. Dieser gibt an, bei welcher Temperatur noch 95 % der Ursprungsmasse erhalten sind. Alle drei gemessenen Matrixmaterialien haben einen T₉₅-Wert über 450 °C und erfüllen somit die Anforderungen an ein Konversionselement oder Verkapselungsmaterial, Temperaturen von 200 °C zersetzungsfrei zu bestehen.

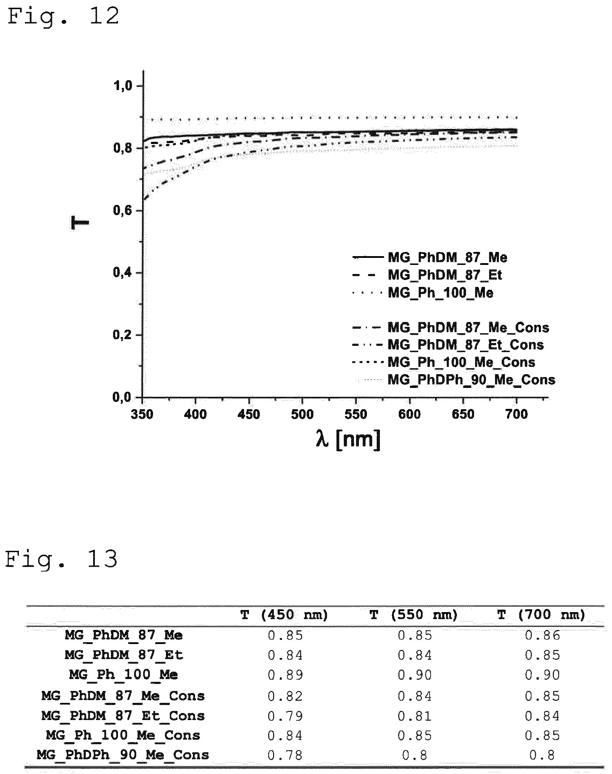

Die Figur 12 zeigt UV/VIS-Spektren für Matrixmaterialien gemäß einer Ausführungsform mit einer Dicke von 2 mm. Es ist die Transmission T in Abhängigkeit der Wellenlänge λ in nm dargestellt. Um die Transparenz der Matrixmaterialien vor und nach der Konsolidierung zu untersuchen, wurden diese in 2 mm-Aluminiumformen mit einem konzentrischen Rundausschnitt von 8 mm gegossen (siehe Figur 4C). Lediglich die Probe MG_PhDPh_90_Me wurde erst im konsolidierten Zustand gemessen.

Die Figur 13 zeigt die Transmissionswerte der Matrixmaterialien bei 450, 550 und 700 nm. Alle gemessenen Probenkörper zeigen eine hohe Transparenz von mindestens 78%. Die beste gemessene Transparenz nach dem Konsolidieren liegt bei 85%.

Im Folgenden werden Ausführungsformen zur Herstellung des Konversionselements beschrieben:
Darstellung von FC546-TES zur kovalenten Integration in das Matrixmaterial

LG305 konnte durch Toluol vollständig aus dem Matrixmaterial ausgelaugt werden. Um dieses in Zukunft zu verhindern und um eine noch höhere Fotostabilität zu erreichen, wurde der bisher zum kovalenten Einbau in hydrosilylierbare Polysiloxane verwendete Farbstoff FC546 mit Triethoxysilangruppen modifiziert. Hierzu wird FC546-TES, wie zuvor LG305, in die Synthese des Matrixmaterials eingebracht.

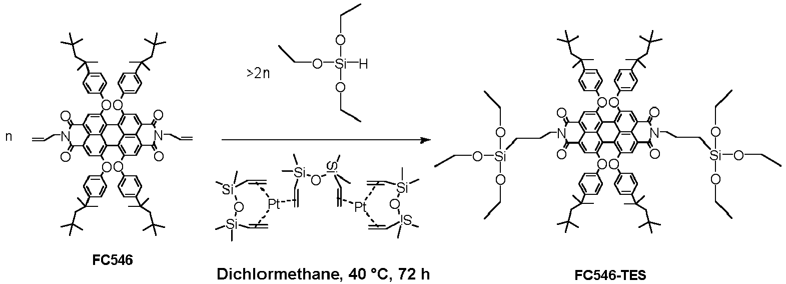

Zur Darstellung von FC546-TES wurde FC546 (0.05 g, 38.97 µmol) in Dichlormethan (6 ml, 7.98 g, 93.95 mmol) gelöst und mit Triethoxysilan (0.128 g, 779.56 µmol) sowie Platin-Divinyltetramethyldisiloxan (Karstedt-Katalysator; 2.0 µl [2.0 % Pt(0) in Xylol]; 0.041 mg Pt(0); 820 ppm bezogen auf m[FC546]) unter Rückfluss gerührt (40 °C, 72 h). Das Lösungsmittel und nicht umgesetztes Triethoxysilan wurden unter vermindertem Druck entfernt (10⁻² mbar). Das erhaltene dunkelrote Pulver wurde isoliert und mittels NMR- und IR-Spektroskopie charakterisiert. Das Produkt konnte mit einer Kleinstmenge an Verunreinigung durch Triethoxysilan erhalten werden. Eine optionale Aufreinigung mittels Säulenchromatographie kann erfolgen.

Darstellung von Dimethylphenylhaltigem Matrixmaterial (13/87) aus Methoxysilanen und Einbringung von Lumogen® F 305 Rot [MG-PhDM-87-Me]

Zur Darstellung eines Matrixmaterials aus Methoxysilanen mit einem prozentualen Si-Ph-zu-Si-Me₂-Verhältnis von 87/13 wurde Phenyltrimethoxysilan ([SiPh(OMe)₃], 31.5 g, 158.86 mmol) in Salzsäure gelöst (4.293 g, pH 2.5, 238 mmol [H₂O]) und unter Luftausschluss gerührt (40 °C, 6 h). Anschließend wurde Dimethyldimethoxysilan ([SiMe₂(OMe)₂], 2.865 g, 23.83 mmol) und absolutes Methanol (3.054 g, 3.856 ml, 95.33 mmol) zugegeben und weiter gerührt (40 °C, 2 h). Das Gemisch wurde geteilt und in Bechergläser (400 ml) transferiert. Einem Teil wurde Lumogen® F 305 Rot zugesetzt (9 mg, 8.34 µmol). Beide Gemische wurden offen gerührt (25 °C, 12 h) und anschließend in einem Trockenschrank erhitzt (70 °C, 24 h; 2. 110 °C, 24 h). Die erhaltenen klaren Produkte wurden anschließend auf Raumtemperatur abgekühlt. Nach jedem Schritt wurde ein Teil der Proben entnommen, um diese NMR-spektroskopisch zu untersuchen (siehe folgende Tabelle).

| Probenname | TMS/DMS | Ph/Me | c(LG305) | Optischer Eindruck bei Raumtemperatur |
|---|---|---|---|---|
| [MG-DMP-87-Me] | 87/13 | 77/23 | 0 | farblos, transparent |
| [MG-DMP-87-Me-LG305-1000] | 87/13 | 77/23 | 1000 ppm µmol/kg | rot, transparent |

Beide Materialien sind bei 110 °C aufschmelzbar und fließen. Bei Raumtemperatur sind die Produkte hart aber formbar bei hohem Druck. LG305 hat sich vollständig in dem Matrixmaterial gelöst. DMP-Me-MG-87-LG305-1000 wurde in einer Aluminiumform bei 160 °C für 72 h konsolidiert, um weitere Untersuchungen durchzuführen. Dieses wird im Folgenden als MG(Kons.)-DMP-87-Me-LG305-1000 bezeichnet.

Darstellung von Dimethylphenylhaltigem Matrixmaterial (13/87) aus Ethoxysilanen und Einbringung von Lumogen® F 305 Rot [MG-PhDM-87-Et]

Zur Darstellung eines Matrixmaterials aus Ethoxysilanen mit einem prozentualen Si-Ph-zu-Si-Me₂-Verhältnis von 87/13 wurde Phenyltriethoxysilan ([SiPh(OEt)₃], 25.5 g, 106.09 mmol) in Salzsäure gelöst (2.867 g, pH 2.5, 159.13 mmol [H₂O]) und unter Luftausschluss gerührt (40 °C, 6 h). Anschließend wurde Dimethyldiethoxysilan ([SiMe₂(OEt)₂], 2.350 g, 15.85 mmol) und absolutes Ethanol (2.921 g, 3.688 ml, 63.394 mmol) zugegeben und weiter gerührt (40 °C, 2 h). Das Gemisch wurde geteilt und in Bechergläser (400 ml) transferiert. Einem Teil wurde FC545-TES zugesetzt (6 mg, 5.56 µmol). Beide Gemische wurden offen gerührt (25 °C, 12 h) und anschließend in einem Trockenschrank erhitzt (70 °C, 24 h). Der zweite Temperaturschritt wurde nun systematisch untersucht. Die erhaltenen klaren Produkte wurden anschließend auf Raumtemperatur abgekühlt (siehe folgende Tabelle).

| Probenname | TMS/DMS | Ph/Me | c(LG305) | Optischer Eindruck bei Raumtemperatur |
|---|---|---|---|---|
| [MG-DMP-87-Et] | 87/13 | 77/23 | 0 | farblos, transparent |
| [MG-DMP-87-Et-FC546-TES-1000] | 87/13 | 77/23 | 1000 ppm 926,6 µmol/kg | rot, transparent |

Beide Materialien sind bei 110 °C aufschmelzbar und fließen. Bei Raumtemperatur sind die Produkte hart aber formbar bei hohem Druck. FC546-TES hat sich vollständig in dem Matrixmaterial gelöst.

Darstellung von Phenylhaltigem Matrixmaterial (100/0) aus Ethoxysilanen und Einbringung von Lumogen® F 305 Rot [MG-Ph-100-Me]

Zur Darstellung eines Matrixmaterials aus Methoxysilanen mit einem prozentualen Si-Ph-Gehalt von 100 wurde Phenyltriethoxysilan ([SiPh(OMe)₃], 25.0 g, 126.08 mmol) in Salzsäure gelöst (3.407 g, pH 2.5, 189.12 mmol [H₂O]) und unter Luftausschluss gerührt (40 °C, 6 h). Anschließend wurde absolutes Methanol (1.795 g, 2.267 ml, 56.032 mmol) zugegeben und weiter gerührt (40 °C, 2 h). Das Gemisch wurde geteilt und in Bechergläser (400 ml) transferiert. Einem Teil wurde Lumogen® F 305 Rot zugesetzt (∼ 6 mg, 5.56 µmol). Beide Gemische wurden offen gerührt (25 °C, 12 h) und anschließend in einem Trockenschrank erhitzt (70 °C, 24 h; 2. 110 °C, 24 h). Die erhaltenen klaren Produkte wurden anschließend auf Raumtemperatur abgekühlt (siehe folgende Tabelle).

| Probenname | TMS/DMS | Ph/Me | c(LG305) | Optischer Eindruck bei Raumtemperatur |
|---|---|---|---|---|
| [MG-Ph-100-Me] | 100/0 | 100/0 | 0 | farblos, transparent |
| [MG-Ph-100-Me-LG305-1000] | 100/0 | 100/0 | 1000 ppm 926,6 µmol/kg | rot, transparent |

Beide Materialien sind bei 110 °C aufschmelzbar und fließen. Bei Raumtemperatur sind die Produkte hart aber formbar bei hohem Druck. LG305 hat sich vollständig in dem Matrixmaterial gelöst.

Darstellung von Phenyldiphenylhaltigem Matrixmaterial (90/10) aus Methoxysilanen und Einbringung von Lumogen® F 305 Rot [MG-PhDPh-90-Me]

Zur Darstellung eines Matrixmaterials aus Methoxysilanen mit einem prozentualen Si-Ph-zu-Si-Ph₂-Verhätnis von 90/10 wurde Phenyltrimethoxysilan ([SiPh(OMe)₃], 25.0 g, 126.08 mmol) in Salzsäure gelöst (3.407 g, pH 2.5, 189.117 mmol [H₂O]) und unter Luftausschluss gerührt (40 °C, 6 h). Anschließend wurde Diphenyldimethoxysilan ([SiPh₂(OMe)₂], 3.423 g, 14.01 mmol) und absolutes Methanol (1.795 g, 2.267 ml, 56.032 mmol) zugegeben und weiter gerührt (40 °C, 2 h). Das Gemisch wurde geteilt und in Bechergläser (400 ml) transferiert. Einem Teil wurde Lumogen® F 305 Rot zugesetzt (8 mg, 8.34 µmol). Beide Gemische wurden offen gerührt (25 °C, 12 h) und anschließend in einem Trockenschrank erhitzt (70 °C, 24 h; 2. 110 °C, 24 h). Die erhaltenen klaren Produkte wurden anschließend auf Raumtemperatur abgekühlt. Nach jedem Schritt wurde ein Teil der Proben entnommen, um diese NMR-spektroskopisch zu untersuchen (siehe folgende Tabelle).

| Probenname | TMS/DMS | Ph/Me | c(LG305) | Optischer Eindruck bei Raumtemperatur |
|---|---|---|---|---|
| [MG-PhDPh-90-Me] | 90/10 | 82/18 | 0 | farblos, transparent |
| [MG-PhDPh-90-Me -LG305-1000] | 90/10 | 82/18 | 1000 ppm 926,6 µmol/kg | rot, transparent |

Beide Materialien sind bei 110 °C aufschmelzbar und fließen. Bei Raumtemperatur sind die Produkte hart aber formbar bei hohem Druck. LG305 ist vollständig in der Matrix gelöst. Die in Verbindung mit den Figuren beschriebenen Ausführungsbeispiele und deren Merkmale können gemäß weiterer Ausführungsbeispiele auch miteinander kombiniert werden, auch wenn solche Kombinationen nicht explizit in den Figuren gezeigt sind. Weiterhin können die in Verbindung mit den Figuren beschriebenen Ausführungsbeispiele zusätzliche oder alternative Merkmale gemäß der Beschreibung im allgemeinen Teil aufweisen.

Die Erfindung ist nicht durch die Beschreibung anhand der Ausführungsbeispiele auf diese beschränkt. Vielmehr umfasst die Erfindung jedes neue Merkmal sowie jede Kombination von Merkmalen, was insbesondere jede Kombination von Merkmalen in den Patentansprüchen beinhaltet, auch wenn dieses Merkmal oder diese Kombination selbst nicht explizit in den Patentansprüchen oder Ausführungsbeispielen angegeben ist.

### Bezugszeichenliste

100 Konversionselement
1000 optoelektronisches Bauelement
1 Konversionsmaterial
2 Matrixmaterial
3 TAS, Trialkoxysiloxan oder Trialkoxysiloxanmonomereinheiten
4 DAS, Dialkoxysilan oder Dialkoxysilanmonomereinheiten,
5 Halbleiterschichtenfolge
6 Primärstrahlung
7 Sekundärstrahlung
8 Gehäuse
9 Ausnehmung
11 Substrat
MM oder MG Matrixmaterial
G, g Gel
NB Nebenprodukt
F Filtration
HC Hybridbeschichtung

## Patentansprüche

1. Konversionselement (100) für ein optoelektronisches Bauelement (1000) umfassend
- zumindest ein Konversionsmaterial (1), das zur Wellenlängenkonversion eingerichtet ist,
- ein polymeres Matrixmaterial (2), das durch eine Kondensationsreaktion von Trialkoxysilan- und Dialkoxysilanmonomereinheiten (3, 4) erzeugt ist,
wobei das Konversionsmaterial (1) in dem Matrixmaterial (2) eingebettet ist.

2. Konversionselement nach Anspruch 1,
wobei das Matrixmaterial (1) bei Raumtemperatur fest oder gelartig ist und/oder wobei das Konversionsmaterial (1) ein organischer Fluoreszenzfarbstoff ist oder wobei das Konversionsmaterial (1) ein anorganischer Leuchtstoff ist.

3. Konversionselement nach Anspruch 2,
wobei der organische Fluoreszenzfarbstoff auf Perlyendiimid basiert.

4. Konversionselement nach einem der vorhergehenden Ansprüche,
wobei das Konversionsmaterial (1) an dem Matrixmaterial (2) kovalent angebunden ist.

5. Konversionselement nach einem der vorhergehenden Ansprüche,
wobei das Konversionsmaterial (1) an dem Matrixmaterial (2) nicht-kovalent angebunden ist.

6. Konversionselement nach einem der vorhergehenden Ansprüche,
wobei die Trialkoxysilanmonomereinheit (3) die Struktur (I) 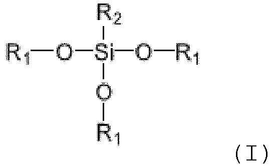 und die Dialkoxysilanmonomereinheit (4) die Struktur (II) 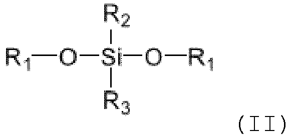 aufweist,
wobei R₁ für die jeweilige Trialkoxysilan- oder Dialkoxysilanmonomereinheit (3, 4) unabhängig voneinander aus Methyl oder Ethyl ausgewählt ist,
wobei R₂, R₃ für die jeweilige Trialkoxysilan- oder Dialkoxysilanmonomereinheit (3, 4) unabhängig voneinander aus Methyl oder Phenyl ausgewählt sind.

7. Konversionselement nach einem der vorhergehenden Ansprüche,
wobei die Trialkoxysilanmonomereinheiten (3) verglichen mit den Dialkoxysilanmonomereinheiten (4) im Überschuss in dem Matrixmaterial (2) vorhanden sind.

8. Konversionselement nach einem der vorhergehenden Ansprüche,
wobei das Matrixmaterial (1) frei von einem Edelmetall-Katalysator ist.

9. Konversionselement nach einem der vorhergehenden Ansprüche,
wobei das Matrixmaterial (2) bei einer Temperatur zwischen 150 °C und 200 °C aushärtet und vollständig vernetzt ist.

10. Konversionselement nach einem der vorhergehenden Ansprüche,
wobei das Verhältnis von Trialkoxysilan- zu Dialkoxysilanmonomereinheiten (3, 4) zwischen 85 zu 15 und 99 zu 1 bezogen auf das Matrixmaterial (1) liegt.

11. Optoelektronisches Bauelement (1000) aufweisend
- eine Halbleiterschichtenfolge (5), die zur Emission von Primärstrahlung (6) eingerichtet ist,
- ein Konversionselement (100) nach zumindest einem der Ansprüche 1 bis 10, wobei das Konversionselement (100) im Strahlengang der Primärstrahlung (6) angeordnet ist und zur Umwandlung der Primärstrahlung (6) in Sekundärstrahlung (7) eingerichtet ist.

12. Optoelektronisches Bauelement (1000) nach Anspruch 11, wobei das Konversionselement (100) die Halbleiterschichtenfolge (5) vollständig umhüllt oder wobei das Konversionselement (100) von der Halbleiterschichtenfolge (5) beabstandet angeordnet ist.

13. Optoelektronisches Bauelement nach Anspruch 11 oder 12, wobei das Matrixmaterial (2) ohne Edelmetall-Katalysator erzeugt wird und thermisch ohne Zusatz weiterer Komponenten ausgehärtet wird.

14. Verfahren zur Herstellung eines optoelektronischen Bauelements (1000) umfassend die Schritte:
A) Bereitstellen einer Halbleiterschichtenfolge (5), die zur Emission von Primärstrahlung (6) eingerichtet ist,
B) Bereitstellen eines Konversionselements (100), das zur Umwandlung der Primärstrahlung (6) in Sekundärstrahlung (7) eingerichtet ist, dazu:
B1) Erzeugen eines Matrixmaterials (2), dazu:
B11) säurekatalysierte Hydrolyse von Trialkoxysilan (3), wobei durch Kondensation teilvernetzte Strukturen erzeugt werden,
B12) Einbau von Dialkoxysilan (4) in die teilvernetzen Strukturen zur Ausbildung eines Gels,
B13) Kondensation des Gels bei einer Temperatur zwischen 100 und 110 °C zur Erzeugung des Matrixmaterials (2), und
B2) Einbetten eines Konversionsmaterials (1) in das Matrixmaterial (2).

15. Polymeres Matrixmaterial (2) für ein optoelektronisches Bauelement (1000), das durch eine Kondensationsreaktion von Trialkoxysilan- und Dialkoxysilanmonomereinheiten (3, 4) erhältlich ist.
